# EUROPEAN PATENT APPLICATION

(11) **EP 4 756 071 A1**
(43) Date of publication of application: **10.06.2026**
(21) Application number: 24307028.1
(22) Date of filing: 04.12.2024
(51) Int. Cl.: C23C 16/04, C23C 16/18, C23C 16/40, C23C 16/48

(54) **METHOD FOR DEPOSITING A METAL ONTO A SAMPLE BY FOCUSED CHARGED PARTICLE BEAM INDUCED DEPOSITION**

(71) Applicant: Orsay Physics, 13710 Fuveau (FR)
(72) Inventor: LEGAL, Pierre, 13600 LA CIOTAT (FR); GOUPIL, Gregory, 83560 RIANS (FR)
(74) Representative: Harber IP s.r.o.

(57) **Abstract**

The present invention provides a method for depositing a metal or metal oxide onto a sample by focused charged particle beam induced deposition, wherein the sample is introduced into a working chamber of a focused charged particle beam device, and subjected to processing by a beam containing focused charged particles and by a stream of a gaseous precursor of the metal or metal oxide to be deposited and water vapor, wherein the gaseous precursor of the metal or metal oxide to be deposited and water vapor are produced in one reservoir from a liquid or solid precursor of the metal or metal oxide to be deposited and from a liquid or solid precursor of water vapor, and introduced from the reservoir into the working chamber by a single nozzle.

## Description

### Field of Art

The invention relates to improvements in the methods for depositing a metal onto a sample by focused charged particle beam induced deposition.

### Background Art

Gas-assisted nano-prototyping of structures using focused charged particle beams is known as focused electron beam induced deposition (FEBID) when using an electron beam as primary beam or focused ion beam induced deposition (FIBID) when the primary beam is composed of accelerated ions. In these techniques, a local injection of precursor molecules is done into a vacuum chamber through a gas injection system (GIS). These molecules are present in gas phase at low pressure in order not to break the vacuum in the chamber. These injected molecules are then adsorbed on the sample surface and a focused beam is scanned over the region of interest. The physical processes involved rely on the ability of the primary beam and the generated secondary electrons (SE) to dissociate the molecules delivered by the nozzle and adsorbed onto the surface, by breaking some of the bonds of the molecule and creating volatile products (mainly Hand O-related compounds) while depositing the desired element. Depending on the shape and the scanning strategy used on the sample surface, it is then possible to create a nanostructure directly on the selected area. This nano-printing method using a focused electron beam (FEB) or a focused ion beam (FIB) is very attractive, flexible and rather simple to implement.

Nevertheless, the composition of the injected molecule and the physical parameters involved in this process introduce some artifacts in the final deposit. Among all the deposition possibilities, generally only few elements can be deposited and mostly platinum, tungsten, insulator and carbon are deposited by these techniques. The main reason is the amount of the initial precursor injected to realize the surface reaction. For example, to realize a platinum deposition, the initial precursor cannot be pure platinum mainly because of the high temperature needed to vaporize this metal. To overcome this issue, platinum is injected using a salt or complex containing atoms of platinum as the precursor. To do so, a gas injection nozzle is closely placed above the surface of the sample, typically few hundred µm, at a certain angle, in an arrangement that does not disturb the ion path to the sample (typically, 30 to 60°). The injector is connected to a gas reservoir, which contains the precursor in a gaseous, liquid, or solid form, with a heater to achieve and control the ejection of the gas through the nozzle. Similar procedures and salt or complex precursors are also used for other metals. The precursors contain inorganic or organic ligands to increase the volatility, which however results in the presence of carbon usually in higher content than the amount of the element to be deposited. Pure and homogeneous final deposition compositions are intrinsically hindered due to various aspects of the deposition process, such as incomplete dissociation of the precursor molecules and the residual contamination from hydrocarbons present in the vacuum chamber, both of which result in carbon content in the nanostructure. In addition to the surface processes, the deposition structure strongly depends on multiple growth conditions, such as the primary beam (electron or ions), acceleration voltage, beam current, dose, beam dwell time, scanning strategy, substrate type (insulating or conductive), gas injection nozzle position, precursor molecule (vapor pressure, sticking coefficient to the surface, residence time, dissociation cross-section), precursor temperature, base and process pressure in the vacuum chamber, among others. This makes this deposition process highly dependent on the experience of the user. In general, the result of the deposition is a mixture of the desired compound material, with some residual carbon in most of the cases. The presence of the carbon or other impurities generally changes or disturbs the properties of the deposited material, and is in general undesirable. The severity of the problems caused by the presence of impurities depends on the intended application.

Several studies are focusing on controlling the metal purity by reducing the carbon content of the as-deposited structure. To do so, different ways are explored:
The first option is to reduce or even remove the carbon content in the initial precursor used. The aim is to reduce the co-deposition of carbon from the molecule itself. The main drawback of this solution is that the substituting ligands are fluorine, sulfur or phosphines. During the decomposition by irradiation, these elements can react with the substrates (mainly Si based) causing undesired milling or contamination. Such ligands are less stable than the carbon-based ones preferred by the industrials also because they are more reactive and can cause deterioration of microscope parts.

If the carbon cannot be removed from the precursor molecule, studies suggest to find organic ligands containing as much oxygen or fluorine as possible. The goal is to favor oxidation of the carbon during the process of FEBID or FIBID in order to produce volatile COₓ or CFₓ molecules easily pumped away by the vacuum system of the working chamber and so less likely to be trapped within the deposited structure. For the fluorinated molecules, as before, the main drawback is the corrosive aspect of the salt that is generally unacceptable for the industrial suppliers of precursors for gas injection systems.

Another way to improve the purity is to control the sample temperature. The user can favor surface adsorption of the precursor on the surface by cooling the sample or the desorption of the molecule by increasing the temperature of the sample. The cooling process is usually used when the deposition speed is the key of the application. In this case, the precursor is "frozen" and the process is not limited by the surface absorption. Even if the process is fast, it generally induces a larger amount of carbon in the final deposition due to the trapping of the initial precursor and also by trapping all the carbonated molecules desorbed by the chamber by acting as a cold trap. The heating process reduces drastically the absorption coefficient of the molecules thus reducing the speed of the deposition process. Nevertheless, because of the energy brought to the sample surface, this heating favors the thermal cracking of the initial precursor as well as helps to desorb the ligands during the FEBID or FIBID processes. Only the heavy elements of the initial precursor remain on the surface, which are generally the ones to be deposited. This heating process can be done during the deposition process or done as a post-processing step.

In some studies, thermal annealing or plasma treatments are carried out to decrease the carbon content of the as-deposited structure. As for the addition of oxygen in the initial precursor to balance the amount of carbon and favor the creation of COₓ molecules during the FEBID or FIBID process, it is possible to introduce these oxidative elements toward a controlled partial pressure in the microscope chamber during or after the deposition process. Coupled with a temperature-controlled stage, it is also possible to generate thermal reactions producing volatile carbonated products helping to purify the deposit. This process is mainly done by irradiating the deposited structure using a SEM to prevent an unwanted milling of the structure by the FIB. The goal is to remove only the carbon and not the element to be purified.

Pure metals and oxides were obtained by co-injection of a precursor containing the element to be deposited and a reducing agent such as water, oxygen or hydrogen. The process is focused on favoring the formation of volatile carbon-based molecules, but the main difference is that this process is done simultaneously to the deposition. The two gases are injected using a coaxial nozzle gathering the two gas flows in a suitable ratio. The two precursors can also be injected by using two nozzles positioned to focus the two gas flows at the area of the sample. However, this system requires two reservoirs and two systems leading the gas to the nozzles, which results in an increased complexity and cost of the device used for the deposition.

### Disclosure of the Invention

The present invention is based on the finding that the precursor of the metal to be deposited and the precursor of water vapor can be inserted into one single reservoir and introduced by one single nozzle into the working chamber of a device for focused charged particle beam induced deposition. The speed of formation of water vapor should be adapted to the amount of water vapor needed to be supplied in order to achieve the required purity of the deposit (deposited metal).

The present invention provides a method for depositing a metal or metal oxide onto a sample by focused charged particle beam induced deposition, wherein the sample is introduced into a working chamber of a focused charged particle beam device, and subjected to processing by a beam containing focused charged particles, and by a stream of a gaseous precursor of the metal to be deposited and water vapor, wherein the gaseous precursor of the metal to be deposited and water vapor are produced in one reservoir from liquid or solid precursors and introduced into the working chamber by a single nozzle.

The focused charged particle beam induced deposition is preferably selected from focused electron beam induced deposition (FEBID) or by focused ion beam induced deposition (FIBID). Charged particles are thus preferably electrons or ions.

A focused charged particle beam device for depositing metal onto a sample typically comprises a working chamber configured so that a charged particle source is beamed into the working chamber, and the device further comprises an optical system (e.g., a lens system) for focusing the charged particle beam and a support for holding the sample, wherein a nozzle for supplying the gaseous precursor of the metal to be deposited and water vapor extends into the working chamber and is configured so that the gaseous precursor of the metal to be deposited and water vapor can be introduced into the vicinity of the sample. According to the invention, the nozzle for supplying the gaseous precursor of the metal to be deposited and water vapor is connected to a reservoir for containing a liquid or solid precursor of the metal to be deposited and a liquid or solid precursor of water vapor. Further, the device may include at least one valve for controlling the amount of gaseous mixture of the gaseous precursor of the metal to be deposited and water vapor supplied. The working chamber may further comprise at least one imaging or working lens tube.

It is noted that the device of the invention contains exactly one nozzle configured for supplying the gaseous precursor of the metal to be deposited together with water vapor and exactly one reservoir configured to contain a liquid or solid precursor of the metal to be deposited and a liquid or solid precursor of water vapor. Alternatively, the device may comprise additional nozzles and reservoirs in addition to this exactly one nozzle, wherein these additional nozzles and reservoirs are configured to contain other working liquids, solids or gases than the precursor of the metal to be deposited or the precursor of water vapor.

The precursor of the metal to be deposited is typically a salt or complex of the metal to be deposited.

The precursor of water vapor may be a hydrated inorganic salt, preferably magnesium sulfate hydrates (such as magnesium sulfate heptahydrate (MgSC₄.7H₂O, epsomite), magnesium sulfate hexahydrate or other partially hydrated forms), magnesium bromide hydrates (such as magnesium bromide hexahydrate (MgBr₂.6H₂O) or its partially hydrated forms), potassium sodium tartrate hydrates (such as potassium sodium tartrate tetrahydrate (KNaC₄H₄O₆.4H₂O) or its partially hydrated forms), sodium phosphate dibasic hydrates (such as sodium phosphate dibasic heptahydrate (Na₂HPO₄.7H₂O) or its partially hydrated forms), and/or a superabsorbent polymer with absorbed water.

Superabsorbent polymer may preferably be a polyacrylate, more preferably selected from sodium polyacrylate or potassium polyacrylate. These polymers have a molecular weight Mw typically within the range of 1,000 g/mol to 90,000 g/mol.

The operating conditions in the device reservoir are defined by the operating temperature, which may be a normal laboratory temperature or a controlled temperature of less than 30 °C, less than 50 °C, or less than 80 °C. The working chamber pressure is typically between 1.10⁻¹ Pa and 1.10⁻⁵ Pa. The magnitude of the working pressure of the gas in the working chamber depends mainly on the volume of the working chamber and the performance of the pumping system, the characteristics of the system of tubing for introduction of the precursor, in particular the length of the tubing, the diameter of the nozzle capillary, the control mechanisms, and the saturation vapor pressure of the precursor in the reservoir. The saturation vapor pressure of the auxiliary or working gas in the reservoir is primarily influenced by the temperature of the reservoir, and by the hydration degree of the inorganic salts or by the content of water absorbed in the superabsorbent polymer.

In order to achieve a good purity and quality of the deposit on the sample, the water vapor needs to be introduced in an appropriate ratio (or appropriate range of ratios) to the gaseous precursor of the metal to be deposited. As both water vapor precursor and liquid or solid precursor of the metal are placed together in one single reservoir, their partial pressures need to be in the appropriate ratio (or appropriate range of ratios). This can be achieved by selecting a water vapor precursor having an appropriate partial pressure under the pressure and temperature conditions to be used. Methods of determining partial pressures and literature resources for finding information about partial pressures are known to a skilled person.

For example, the lifetime of the liquid or solid precursor of the metal to be deposited, without precursor of water vapor, is determined as the period for which a pre-determined amount (amount having a pre-determined weight) is lasting at the operation temperature of the device in the reservoir. The lifetime of the liquid or solid precursor of water vapor is determined as the period for which the same pre-determined amount (amount having the pre-determined weight) is lasting at the operation temperature of the device in the reservoir. The weight ratio of both precursors is adjusted so that the same lifetime is obtained.

For a person skilled in art, the injection pressure of a precursor into a chamber using a GIS is determined by checking the difference between the vacuum level of the chamber when no gas is introduced versus the pressure when injecting a precursor at a selected heating temperature. An abacus is then created for the supplier who will know for each precursor in each condition its partial pressure. As the inorganic salts have various levels of hydration, it is first important to select a hydrated salt and its hydration level before measuring the partial pressure of each of these levels.

By using thermogravimetric analysis (TGA) performed in the same vacuum environment than the microscope, the dehydration level of the salt versus the temperature is characterized. With this curve it is possible to determine the condition of preparation of the (partially) hydrated inorganic salt to reach the suitable hydration level required. The hydration level selected is directly linked with the operation temperature of the precursor mixed with the (partially) hydrated inorganic salt to avoid a too high injection pressure.

For example, it is possible to extract data from the literature in order to estimate the partial pressure of the various hydration levels of the magnesium sulfate salt regarding the hydration level versus the temperature (e.g., https://doi.org/10.1016/j.tca.2017.08.015).

For example, if the precursor is generally heated at 60°C to reach a good injection pressure, the hydration level of the water vapor precursor selected is the one reaching a corresponding pressure at 60°C on the TGA curve. In the real cases studied, a higher hydration level of the magnesium sulfate salt can be preferred to be used as the gas flow induced by the mixture of the precursors is then higher than the metal precursor alone leading to a lower operating temperature for the mixture of precursors to reach good deposition conditions. In a practical way, as soon as the hydration level of the magnesium sulfate salt (or another water vapor precursor) is selected, it is possible to determine its operating lifetime by measuring how long the injection pressure remains stable for 1g (or another pre-determined amount) introduced in the reservoir. Then, this lifetime is adjusted to fit with the targeted lifetime of the mixture of the precursors (water vapor precursor and metal precursor). Furthermore, the ratio of amounts of the water vapor precursor and liquid or solid precursor of the metal determines the ratio of the amounts of their gaseous states to be injected into the working chamber. Furthermore, the partial pressures of both or all precursors can be further fine-tuned by selecting a suitable temperature of the reservoir and by the pressure in the system.

Magnesium sulfate heptahydrate (MgSO₄.7H₂O, epsomite) or its lower hydration levels (hydrates) is commonly used as a source of water vapor in systems with multiple reservoirs, where separate reservoirs are dedicated to precursor of metal to be deposited and to precursor water vapor, respectively. Any disclosure referring to magnesium sulfate in this text also applies analogously for other hydrated salts listed herein as other precursors of water vapor and for superabsorbent polymers with absorbed water. Other precursors of water vapor can be magnesium bromide hexahydrate (MgBr₂.6H₂O) or its lower hydration levels (hydrates), potassium sodium tartrate tetrahydrate (KNaC₄H₄O₆.4H₂O) or its lower hydration levels (hydrates), sodium phosphate dibasic heptahydrate (Na₂HPO₄.7H₂O) or its lower hydration levels (hydrates). Generally, hydrated salts not being corrosive and/or not creating interaction with the gaseous precursor mixture and the cartridge itself can be used as sources of water vapor. The vapor pressure of the hydrated salt has to be sufficient to be injected in the vacuum chamber and the salt needs to allow heating range from 20°C to 100°C without any decomposition.

Hydrated magnesium sulfate is preferred in this invention as a precursor of water vapor. Its multiple hydration grades allow to choose between various partial pressures as needed for mixtures with various precursors of the metals to be deposited. The desired hydration grade of magnesium sulfate salt can be produced by a dedicated process of hydration/dehydration. The level of hydration is selected based on the level of injection pressure needed at the temperature of operation in the mixture with the gaseous precursor of the metal to be deposited, in order to achieve the desired purity and quality of the deposit.

Each hydration grade of magnesium sulfate allows to work with a dedicated vapor pressure of the salt and gives access to a flow of water depending on the heating temperature in the reservoir. As an example, the first dehydration plateau (from heptahydrate to hexahydrate) is commonly used at room temperature because the injection pressure is already high enough to bring a sufficient amount of water molecules to the area of interest. This plateau cannot be used at higher temperature because its vapor pressure would be so high that it would break the vacuum of the chamber. Nevertheless, when preparing this salt and adjusting its hydration level (grade) by a thermal cycle, it becomes possible to inject water molecules in the chamber at a higher temperature such as those classically used for the deposition of organometallics. So, by a precise process of dehydration, it is possible to select one of these hydration levels and adjust it to the metal precursor to be mixed with.

The term "hydration level" refers to the number of water molecules in the hydrated salt (e.g. seven water molecules in epsomite (MgSO₄.7H₂O) or less water molecules in partially dehydrated epsomite (lower hydrate of MgSO₄); similarly for other inorganic salts). It is the variable x in the notation, e.g., MgSO₄.xH₂O.

The invention can be applied with various liquid or solid precursors of the metal to be deposited, which are commonly used in charged particle beam induced deposition. Examples of such metal precursors are:

| | |
|---|---|
| Al(C₄H₉)₃ | Aluminium Triisobutyl |
| C₁₁H₁₉AgO₂ | 2,2,6,6-Tetramethyl-3,5-heptanedionato silver |
| C₆H₅CO₂Ag | Silver benzoate |
| (AgO₂CC₂F₅) | carboxylate complex silver pentafluoropropionate |
| [CH₃COCHCOCH₃]Ag | Silver acac |
| Au(CH₃)₂ (acac) | Dimethyl gold acac |
| Au(CH₃)₂ (hfac) | Dimethyl gold hfac |
| Au(CH₃)₂(tfac) | Dimethyl gold tfac |
| (C₄H₉)₄Au₂F₂ | Tetrakis isobutyl diaurum difluoride |
| CO₂(CO)₈ | Dicobalt octacarbonyl |
| Co₄(CO)₁₂ | Tetracobalt dodecacarbonyl |
| C₅H₅CO(CO)₂ | Cyclopentadienylcobalt dicarbonyl |
| Cr(C₆H₆)₂ | Diarene chromium |
| Cu(hfac)₂xH₂O | Copper (hexafluoroacetylacetonate) hydrate |
| Cu(hfac)₂ | Copper (hexafluoroacetylacetonate) |
| W(CO)₆ | Tungsten hexacarbonyl |
| C₅H₄CH₃Pt(CH₃)₃ | (Trimethyl)methylcyclopentadienylplatinum(IV) |
| (CH₃)₃(C₅H₅)Pt | (Trimethyl)cyclopentadienylplatinum(IV) |
| (CH₃SiHO)₅ | 2,4,6,8,10-Pentamethylcyclopentasiloxane |
| [(CH₃)₂SiO]₃ | Hexamethylcyclotrisiloxane |
| (C₂H₅O)₄Si | Tetraethyl orthosilicate |
| Pd(C₅HF₆O₂)₂ | Palladium hfac |
| Fe(CO)₅ | Pentacarbonyl iron |
| C₈H₈Fe(CO)₃ | Cyclooctatetraene iron tricarbonyl |
| Fe(C₅H₅)₂ | Ferroceneor biscyclopentadienyl iron |
| Ni(C₅H₅)₂ | Nickelocene |
| Ru₃(CO)₁₂ | triruthenium dodecacarbonyl |
| Re₂(CO)₁₀ | Dirhenium decacarbonyl |
| Mo(CO)₆ | Molybdenum hexacarbonyl |
| Cr(CO)₆ | Chromium hexacarbonyl |
| Ta(OC₂H₅)₄(CH₃COCHCOCH₃) | Tetraetoxytantalum acetylacetonate |
| Zr(hfac)₂ | Zirconium hexafluoroacetylacetonate |
| (C₅H₅)₂Ti(CO)₂ | Titanocene dicarbonyl |
| Hf(CH₃COCHCOCH₃)₄ | Hafnium(IV) acac |

By injecting the gaseous precursor of the metal to be deposited together with water vapor in the same injection line (same reservoir, same tubing, same nozzle), the homogeneity is granted all over the area of the sample exposed to the flow. By co-injecting the two gases (metal precursor and water vapor), there are several conditions to consider:

The two gases must be chemically compatible all over the range of operating temperature of the mixture in order not to react directly in a cartridge. This precaution is done to avoid the injection of already decomposed precursors that could lead to injection peaks in the chamber or a reduction of the selected element forming a more stable compound and avoiding its further injection in the chamber. Also, by reacting, a dangerous overpressure could occur in the cartridge containing the precursors that would become harmful for the user. The two gaseous precursor vapor pressures have to fit in order to have a good ratio between the two molecules. If the injection of water vapor would be too high compared to the metal precursor, the deposition would be negligible. And in the opposite case, the carbon oxidation due to the water would not be as efficient as it should be if the injection of water vapor would be too low.

Another advantage of the invention is that co-injection of water also helps for the injection of organometallics acting like a gas carrier for low vapor pressure precursors.

Water is known to have a high sticking coefficient of the surfaces. Even if this is mostly an issue when trying to have a clean high vacuum environment, we observed that the co-injection helps the "hydrated organometallic" precursor mixture to adsorb on the surface leading to a better deposition rate compared to the organometallic precursor alone under the same deposition conditions.

The process of the invention can be done to purify any deposition using a focused charged particle beam such as an electron beam or a ion beam in a vacuum chamber. Adjusting the primary beam and scanning parameters as well as the chamber environment (pressure in the chamber, temperature of the stage...), it is possible to modify the final deposition properties.

The term "metal to be deposited" is intended to include metal or metal oxide which should be deposited using the focused charged particle beam induced deposition technology.

### Examples

### Example 1:

Initial tests were performed to assess the performances of a copper precursor alone, wherein 1 g of Cu(hfac) precursor was used and, in another test, a commercially available hydrated copper precursor Cu(hfac)×H₂O. The comparison showed that the initially hydrated precursor had really good results in terms of purity and deposition rate (0.25 µm3/nA/s) compared to the non-hydrated precursor which has initial purity of 100 % of Cu(hfac) and deposition rate of 0.07 µm3/nA/s. Nevertheless, after few minutes, the performances of the hydrated copper salt are decreasing as well as its injection pressure until reaching the same level as the dehydrated salt at the same temperature. The initial injection pressure of the hydrated salt at 45°C is 1,2.10⁻³ Pa and after few minutes, it drops to 2,1.10⁻⁴ Pa in the same conditions. It was clear that the hydration state of the initial precursor was the key of the good results but this dehydration occurs too fast for the method to be commercially viable. After the dehydration of the hydrated copper precursor, nearly 95% of the copper salt remains in the reservoir.

The next experiment was performed with a mixture of 0,8 g Cu(hfac) and a controlled amount 0,2 g of magnesium sulfate hexahydrate to adjust the injection pressure of both precursors to help the deposition process. The idea of mixing the dehydrated salt with the water vapor precursor magnesium sulfate hexahydrate is to control the amount of water introduced with the copper to be sure to use up all the copper precursor with reliably good results all along the lifetime of the precursor. The level of hydration of the magnesium sulfate was selected mainly because of the operation temperature of the copper precursor and to ensure that the required amount of water vapor and Cu(hfac) precursor is released from the reservoir at the required reservoir temperature of 30°C. An initial dehydration of the Mg(SO₄).7H₂O to Mg(SO₄).6H₂O was performed by heating 10g of the initial salt at 30°C inside a cylinder pumped for 4h. Then this salt was mixed in the weight ratio (8:2) with dehydrated Cu(hfac) to allow for the expected lifetime of the copper precursor. In other words the ratio was chosen in such a way that the amount of water available at the set temperature and pressure in the Mg(SO₄).6H₂O provided an optimum amount of water vapor throughout the deposition of a whole amount of the copper precursor. This induced an increase of the injection pressure to 1.4.10⁻³ Pa compared to the dehydrated copper precursor injection pressure 2.1.10⁻⁴ Pa and fits to the injection observed at the beginning of the operation of the partially hydrated copper precursor Cu(hfac)₂×H₂O injecting at 1.2.10⁻³ Pa at the same temperature.

FIBIP device and method was used, with beam parameters 30 kV - 50 pA.

The hydrated salt also acts as a purifier of deposited copper. Additionally the carry-on effect of water molecules released from Mg(SO₄).6H₂O improves the performance of the precursor, namely increases the pressure of Cu(hfac) precursor vapors in the system which results in a possibility to decrease the temperature for using the copper precursor Cu(hfac). Hence, the copper precursor mixed with Mg(SO₄).6H₂O can be used at a lower temperature (40°C) compared to the copper precursor not mixed with Mg(SO₄).6H₂O (70°C). This leads to a longer lifetime, a higher chemical stability inside the reservoir and gives better results with optimized deposition process (FIBIP/FEBIP). The results are shown in the table below.

| **Copper salt dehydrated, 1 g** | |
|---|---|
| observed deposition rate: 0.13 µm³/nA/s | |
| ELEMENT | PURITY (at.%) |
| **Cu** | **38** |
| F | 8 |
| C | 37 |
| O | 4 |
| Ga | 5 |
| Si | 8 |

| **Dehydrated copper salt 0.8 g + hydrated salt Mg(SO₄).6H₂O 0.2 g** | |
|---|---|
| observed deposition rate: 0.50 µm³/nA/s | |
| ELEMENT | PURITY (at.%) |
| **Cu** | **61** |
| F | 10 |
| C | 7 |
| O | 2 |
| Ga | 5 |
| Si | 15 |

### Example 2:

Magnesium sulfate hexahydrate was used in combination with silicon oxide precursor. The experiment showed that the hydrated salt mixed with the initial silicon oxide precursor (hexamethylcyclotrisiloxane) helps to oxidize the molecules in the reservoir (GIS reservoir). Silicon oxide precursor (hexamethylcyclotrisiloxane) if alone in the reservoir showed a declining deposition rate within time as the water vapors, which water vapor called "residual water" that has entered the reservoir from the air during manufacturing and storage evaporates from the reservoir during the first opening of the valve and entering into the working chamber. The first opening of the valve connecting the reservoir and the working chamber led to the outgas of the remaining residual water from the reservoir. After this outgassing, deposition reproducibility decreased and thickness of the deposition layer was considerably reduced.

As in Example 1, the primary function of the magnesium sulfate hexahydrate salt is to purify the compounds by oxidating the as-deposited parasitic carbon to form volatile COₓ molecules directly in the working chamber. Nevertheless, in this case, the desired element to be deposited is sensitive to oxidation and the energy brought by the FIB is sufficient to form the oxide. The results shown below represent a comparison of deposition using pure hexamethylcyclotrisiloxane and a mixture of hexamethylcyclotrisiloxane with magnesium sulfate hexahydrate in the ratio 9: 1. The deposition conditions were identical in both cases (FIBIP, Ga ions, beam parameters 30 kV - 50 pA, controlled injection pressure at 30°C). While, in the case of hexamethylcyclotrisiloxane we were able to form only 3 deposit structures, in the case of the mixture hexamethylcyclotrisiloxane with magnesium sulfate hexahydrate we were able to form at least 6 deposits, while the total amount of precursor (or precursor mixture) in the reservoirs was 1 g in both cases.

The addition of the magnesium sulfate hexahydrate does not have to take only into account the amount needed to remove the carbon but also oxygen to adjust the desired oxidation state of the as-deposited element. As an example, for the hexamethylcyclotrisiloxane, the targeted as-deposited composition is SiO₂. Nevertheless, in reality, this deposition is more a mixture of SiOₓ + SiC + C. During deposition, the SiOx content of the deposit is of particular importance as it is generally used for the highly resistive property of the SiO₂ molecule in which a high carbon content is undesirable because of its conductivity property. The ratio between SiOx and C can be influenced, for example, by the deposition rate. A slower deposition generally means a higher SiOx ratio. However, slower deposition is generally not desirable. Another option to increase the SiOx ratio in the deposit is additional purification by the introduction of oxygen or hydrogen molecules at elevated temperatures to the deposit. Using a mixture of magnesium sulfate hexahydrate with hexamethylcyclotrisiloxane, about 12 percent higher SiOx concentration in the deposit was obtained at the same precursor attachment rate and the same ion tube parameters on the same sample. The usual introduction of oxygen together with hexamethylcyclotrisiloxane (or any other usable precursor) requires 2 injectors or an especially adapted GIS with 2 reservoirs and a coaxial nozzle. In the first case, the adjustment of the flows of the 2 GIS and their positioning is difficult because of the competition between water milling, precursor deposition and oxidation of the as-deposited structure requiring multiple trial and error tests before reaching suitable results and only on a very small area of the sample. As soon as the user wants to change a parameter, the adjustment of the nozzles must be done again because their flows compete with each other at the point above the sample. In the case of the double injector, the GIS is dedicated to a single precursor contrary to our solution that brings the possibility to change only a cartridge and with the same arrangement of the GIS, being able to realize this pure deposition. The precursors injection pressure 2.9.10⁻³ Pa fit together at 30°C, and molecules can be injected at the same time to the working area inside the working chamber. If it is necessary to raise the operating temperature of the precursor to e.g. 60 °C and it is necessary to maintain the same water vapor pressure at this temperature as at 30 °C, then it is necessary to choose MgSO₄.3H₂O and for 70°C MgSO₄.2H₂O.

| **SiOx precursor alone, 1 g** | |
|---|---|
| observed deposition rate: 0.169 µm³/nA/s | |
| ELEMENT | PURITY (at.%) |
| Si | 26.6 |
| O | 35.2 |
| C | 33.2 |
| Ga | 5.0 |
| | **61.8%at. SiOₓ** |

| **SiOx precursor 0.9 g + Mg(SO₄).6H₂O 0.1 g** | |
|---|---|
| observed deposition rate: 0.405 µm³/nA/s | |
| ELEMENT | PURITY (at.%) |
| Si | 30.9 |
| O | 42.4 |
| C | 15.9 |
| Ga | 6.7 |
| | **73.3%at. SiOₓ** |

It was observed that using 1 g of pure hexamethylcyclotrisiloxane, only 3 defined structures could be formed, while using 0.9 g hexamethylcyclotrisiloxane with 0.1 g hydrated MgSO₄.6H₂O allowed to form 6 the same defined structures under the same conditions. Subsequent chemical analysis also showed that for the use of pure hexamethylcyclotrisiloxane precursor, the average Si content and C content of the deposit were 27 at.% and 33 at.%, respectively, and for the use of a mixture of 0.9 g of hexamethylcyclotrisiloxane and 0.1 g of MgSO₄.6H₂O, the average Si content was 31 at.% and the average C content was 16 at.%. The at.% content was measured using SEM.

## Claims

1. A method for depositing a metal or metal oxide onto a sample by focused charged particle beam induced deposition, wherein the sample is introduced into a working chamber of a focused charged particle beam device, and subjected to processing by a beam containing focused charged particles and by a stream of a gaseous precursor of the metal or metal oxide to be deposited and water vapor, **characterized in that** the gaseous precursor of the metal or metal oxide to be deposited and water vapor are produced in one reservoir from a liquid or solid precursor of the metal or metal oxide to be deposited and from a liquid or solid precursor of water vapor, and introduced from the reservoir into the working chamber by a single nozzle.

2. The method according to claim 1, wherein the focused charged particle beam induced deposition is preferably selected from focused electron beam induced deposition (FEBID) or by focused ion beam induced deposition (FIBID).

3. The method according to claim 1 or 2, wherein the precursor of the metal or metal oxide to be deposited is typically a salt or complex of the metal to be deposited.

4. The method according to any one of claims 1 to 3, wherein the precursor of water vapor is a hydrated inorganic salt, or a superabsorbent polymer with absorbed water.

5. The method according to any one of claims 1 to 3, wherein the precursor of water vapor is selected from magnesium sulfate heptahydrate, or a lower hydrate of magnesium sulfate than heptahydrate, such as MgSO₄.6H₂O, MgSO₄.3H₂O or MgSO₄.2H₂O.

6. The method according to any one of claims 1 to 5, wherein the liquid or solid precursors of the metal or metal oxide to be deposited and of water vapor are introduced into the reservoir in such a weight ratio and kept in the reservoir at such a temperature that the ratio of the gaseous precursor of the metal or metal oxide to be deposited and water vapor in the stream is suitable for the deposition of the metal or metal oxide and for having about the same lifetime of both precursors.
